# EUROPEAN PATENT SPECIFICATION

(11) **EP 2 445 110 B1**
(45) Date of publication and mention of the grant of the patent: **14.05.2014**
(21) Application number: 10188454.2
(22) Date of filing: 22.10.2010
(51) Int. Cl.: H03K 17/10, H03K 17/12, H03K 17/082, H03K 17/28, H02M 3/158, H02M 1/088

(54) **Gate driver unit for electrical switching device**
Gate-Treibereinheit für eine elektrische Schaltvorrichtung
Unité de commande de porte pour dispositif de commutation électrique

(43) Date of publication of application: 25.04.2012
(73) Proprietor: ABB Research Ltd, 8050 Zürich (CH)
(72) Inventor: Lobsiger, Yanick, 5000, Aarau (CH); Bortis, Dominik, 8052, Zürich (CH); Kolar, Johann Walter, 8044, Zürich (CH); Laitinen, Matti, 02400, Kirkkonummi (FI)
(74) Representative: Kolster Oy Ab

(56) References cited:
- US-A- 5 566 063
- BORTIS D ET AL: "Active Gate Control for Current Balancing of Parallel-Connected IGBT Modules in Solid-State Modulators", IEEE TRANSACTIONS ON PLASMA SCIENCE, IEEE SERVICE CENTER, PISCATAWAY, NJ, US, vol. 36, no. 5, 1 October 2008 (2008-10-01), pages 2632-2637, XP011237226, ISSN: 0093-3813, DOI: DOI:10.1109/TPS.2008.2003971
- PATRICK HOFER-NOSER ET AL: "Monitoring of Paralleled IGBT/Diode Modules", IEEE TRANSACTIONS ON POWER ELECTRONICS, IEEE SERVICE CENTER, PISCATAWAY, NJ, US, vol. 14, no. 3, 1 May 1999 (1999-05-01), XP011043303, ISSN: 0885-8993

## Description

### FIELD OF THE INVENTION

The present invention relates to controlling gate-controlled electrical switching devices, such as MOSFETs, IGBTs, BJTs, and alike.

In particular, the invention relates to cases where switching devices are connected in parallel between a source and a load, and thus need to be controlled in such a way that a load current is evenly shared between the parallel-connected switching devices during all modes of operation.

### BACKGROUND OF THE INVENTION

Parallel-connected switching devices are typically used in applications where high current throughput is required. The parallel connection is in particular needed in inverter bridges feeding high current AC- or DC-loads.

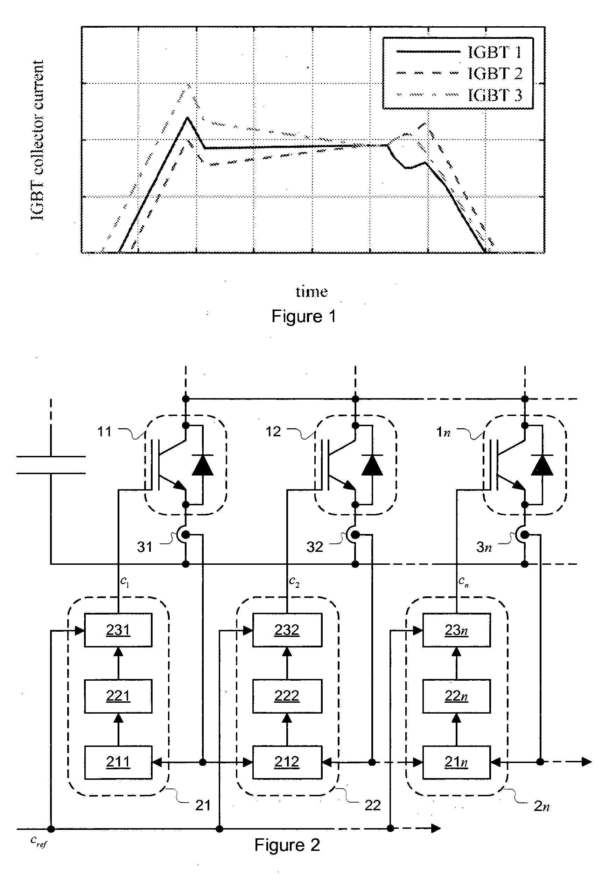

A problem associated with the parallel-connected switching devices is that currents through the switching devices are seldom evenly balanced. Figure 1 illustrates examples of uncompensated schematic current waveforms for three parallel-connected IGBTs. The waveforms show unbalanced current distribution due to differentiating turn-on and turn-off times. Unbalanced currents cause uneven wear and tear in the switching devices. The uneven wear and tear in turn reduce the life-time of the switching devices. Further, unbalanced currents may cause a switching device to reach its maximum temperature rating or maximum current rating faster than when the currents are in balance.

Traditionally parallel-connected power electronic switching devices are derated or additional passive components are added in the current path to reduce the current imbalance, as disclosed in publication B. Abdi, A.H. Ran-jbar, K. Malekian, J. Milimonfared, and G.B. Gharehpetian, "Problems associated with parallel performance of high current semiconductor switches and their remedy," in Proc. Int. Symp. Power Electronics, Electrical Drives, Automation and Motion SPEEDAM 2008, 2008, pp. 1379-1383. However, this approach may be inefficient and costly.

Selection of a component with similar characteristics is also used as a tool to solve the problem, as disclosed in publication Fuji IGBT module application manual, www.fujisemiconductor.com, 2004. However, handpicking the components adds production costs.

In publication Dominik Bortis, Juergen Biela, Johann W. Kolar, "Active gate control for current balancing of parallel-connected IGBT modules in solid-state modulators", IEEE Transactions on Plasma Science, vol. 36, no. 5, pp. 1379-1383, an active current balancing by gate controlling circuits is proposed. The publication discloses utilization of centralized intelligence only. The disclosed method requires a relatively complex measurement and communication system to operate.

Patent publication US5566036A discloses an apparatus and an arrangement for controlling voltages over series-connected switching devices. In the publication, a drive unit (4) is used for adjusting timings of switching events of the switching devices. A measured voltage over the series connection, divided by the amount of switching devices, is used for determining a common reference voltage. A voltage over each switching device is also measured. The timings of switching events are adjusted on the basis of differences between the voltages over the switching devices and the common reference voltage.

### BRIEF DESCRIPTION OF THE INVENTION

An object of the present invention is to provide a method and an apparatus for implementing the method so as to alleviate the above disadvantages. The objects of the invention are achieved by a method and an apparatus which are characterized by what is stated in the independent claims. The preferred embodiments of the invention are disclosed in the dependent claims.

The invention is based on the idea of using intelligent gate driver units (IGDU) with distributed intelligence to control parallel-connected electrical switching devices like IGBTs. The purpose of the intelligence is to balance the currents of the switching devices, even in dynamic switching events. The IGDUs execute the needed measurements independently and establish a needed communication between each other. They may use master-slave or daisy chain control structures and instantaneous or time integral differences of the currents of parallel-connected switching devices as control parameters.

In addition, instead of balancing the currents, the temperature may also be balanced with the intelligent gate driver units. Furthermore, the concept may also be applied to balance the voltages of series-connected power modules.

An advantage of the method and apparatus of the invention is that there is no longer a need for derating of parallel-connected power switching devices, or adding passive components to balance the currents, in dynamic switching events. The cost is therefore reduced. Removing the additional passive components also reduces total power losses.

Distributing intelligence allows more accurate control of individual switching devices as well as faster response to the dynamic changes and failures. It also facilitates specification of both upper control algorithms controlling the IGDUs and communication between an upper control algorithm and intelligent gate driver units.

### BRIEF DESCRIPTION OF THE DRAWINGS

In the following the invention will be described in greater detail by means of preferred embodiments with reference to the accompanying drawings, in which
Figure 1 illustrates examples of uncompensated schematic current waveforms for three parallel-connected IGBTs;
Figure 2 is illustrates a simplified diagram of parallel-connected switching devices;
Figure 3 illustrates an embodiment of the present invention;
Figure 4 illustrates convergence of switching times of four switching devices;
Figure 5 illustrates measured waveforms with and without active switching time correction;
Figure 6 illustrates an embodiment of the present invention, using a master-slave topology; and
Figure 7 illustrates adjustment of switching events to balance currents of parallel-connected switching devices.

### DETAILED DESCRIPTION OF THE INVENTION

An apparatus according to the present invention comprises two or more parallel- or series-connected electrical switching devices, each switching device comprising a control terminal. Figure 2 illustrates a simplified diagram of parallel-connected switching devices 11 to 1*n*. In Figure 2, the switching devices 11 to 1*n* are implemented using power modules. A power module may, for instance, contain a single switching device, a switching device and an antiparallel (free-wheeling) diode (FWD), as in Figure 2, or a half bridge made of these components. In most practical cases, a single power module has more than one internally parallel-connected switching device. Also, other emerging topologies may be incorporated in a single power module.

A decentralized active gate control according to the present invention is accomplished by distributing calculation and correction of imbalance in currents. Thus, the apparatus comprises one or more of intelligent gate driver units. In Figure 2, intelligent gate driver units 21 to 2*n* for the electrical switching devices 11 to 1*n* are shown. In some embodiments, temperatures of the switching devices or voltages over the switching devices may be balanced instead of currents.

Each intelligent gate driver unit 21 to 2n comprises a control output *c₁* to *cₙ* which is adapted to be connected to a control terminal of one of the switching devices 11 to 1*n*. In Figure 2, each of the intelligent gate driver units 21 to 2*n* is connected to a control terminal of one of the switching devices 11 to 1*n*. Each intelligent gate driver unit 21 to 2*n* controls a switching device 11 to 1*n*. Preferably, the IGDUs are equivalent to each other, thus lowering the manufacturing costs. They are all able to operate independently.

As an intelligent gate driver unit has to be able to control a switching device connected to it, each intelligent gate driver unit also comprises means for receiving turn-on and turn-off commands for the switching device from an upper level control. The upper level control produces the turn-on and turn-of commands, on the basis of a control algorithm, for instance a PWM algorithm, to fulfil a desired output voltage and current. The upper level control may, for instance, be implanted using a CPU. The IGDUs share the same control input *c_{ref}* from the upper control level. The control input forms a basis for switching events, but actual switching events are adjusted by the intelligence in the IGDUs and the information shared between them. Transferring information back to the upper controller to adjust the switching events is not required.

The intelligent gate driver units comprise means 211 to 21*n* for receiving feedback information on turn-on and turn-off events of the switching devices controlled by them. Minimum information required to balance a dynamic current sharing is both rising and falling edges of the current at turn-on and turn-off events, respectively. The means 211 to 21*n* for receiving feedback information may for instance be a current measurement with edge detection. The rising and falling edges may be identified by direct current measurement with various methods, for instance by using shunt resistors, current transducers or Rogowski coils. In Figure 2, means 31 to 3*n* are used for current measurement.

Edges can be detected as a voltage drop over an inductance, e.g., the bonding inductance, in the current path or by means of a related value to the current, e.g., the gate-emitter voltage of the semiconductor, as well. The edge information can easily be transferred into digital data by simple comparator circuits.

If an instantaneous, average or RMS value of current is used in balancing, current measurement is needed. For digitizing the instantaneous, average or RMS current data, A/D-conversion means and sampling algorithms are required in IGDUs. In some embodiments, IGDUs may comprise means for measuring a temperature of a temperature difference of a switching device.

To have something to compare the feedback information with, the intelligent gate driver units also comprise means 221 to 22*n* for receiving reference information on device turn-on and turn-off events of another switching device. The reference turn-on and turn-off events are caused by switching devices controlled by other IGDUs. The switching device causing reference events does not always have to be controlled by an IGDU. For example, in embodiments with two parallel switching devices, one of the switching devices may be controlled with a traditional gate driver unit. The other switching device is controlled with an intelligent gate driver unit which receives its reference information from the switching device controlled by the traditional gate driver unit.

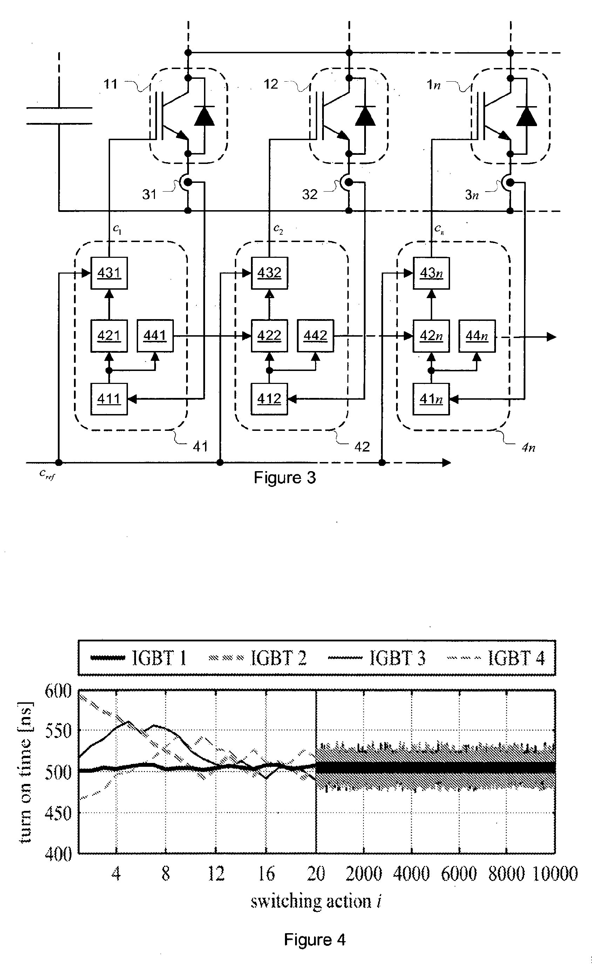

The reference information may be produced by the other IGDUs. One or more of the intelligent gate driver units may be connected to other intelligent gate driver units to receive reference information on turn-on and turn-off events of switching devices controlled by the other intelligent gate driver units. Figure 3 shows an embodiment of the present invention, where each IGDU 41 to 4*n* comprises means 411 to 41*n*, 421 to 42*n*, and 431 to 43*n* similar to the means 211 to 21*n*, 221 to 22*n*, and 231 to 23*n* in Figure 2, respectively. In addition to this, each IGDU 41 to 4*n* comprise means 441 to 44*n* for sending reference information on switching events to the other IGDUs. The means 411 to 41*n* produce feedback information, and the means 441 to 44*n* produce the reference information to be sent from the feedback information. The means 422 to 42*n* are adapted to be connected to the means 441 to 44(*n-1*) for receiving reference information of another intelligent gate driver unit. Each IGDU measures switching events of a switching device connected to the IGDU, and sends the switching event information to other IGDUs. In other words, the IGDUs receive their reference switching events directly from other IGDUs.

Another possibility is that, in addition to being able to detect the events of the switching device connected to the IGDU, each IGDU comprises means to detect the events of another switching device. In other words, one or more of the intelligent gate driver units are connected to other switching devices to receive reference information on turn-on and turn-off events. Figure 2 illustrates this situation.

The times of switching events may be aligned using a daisy chain approach. In the daisy chain approach, the intelligent gate driver units form a daisy chain adapted to pass reference information from one gate driver unit to another. For example, in Figure 2, the IGDU on the left is always the reference to the IGDU ont the right. Thus, eventually, the left most IGDU becomes the reference, but the communication needs to be established only between the neighbours. In some embodiments of the present invention, the first switching device in the daisy chain does not have to be controlled by an IGDU. For instance, if the feedback information is received directly from an external current measurement, as in Figure 2, the first gate driver unit may be a traditional gate driver unit.

Another approach is a master-slave approach. In a master-slave approach, means for receiving reference information of two or more intelligent gate driver units are connected into one source for reference information. For instance, one IGDU may be selected as a master whose switching event information is transferred to all the rest as a reference. The rest then try to follow the master on the basis of the reference. The master may also be a switching device controlled by a traditional gate driver unit. For instance, if the other switching devices are controlled by intelligent gate driver units which receive feedback information directly from an external current measurement, the master does not have to be an IGDU.

Both approaches are possible and the selection of the approach depends on the specific configuration. For example, if an IGDU measures its own and neighbouring currents, as in Figure 2, the daisy chain approach may be more natural.

The minimum reference information required for the comparison is the time of the rising and falling edges. This information can be conveniently transferred as digital signals by using either electrical or optical transducers. The measurement and transforming of the data into digital form may be done in the IGDUs or by using separate means. If other information than reference information on switching events is also transferred between the IGDUs, the same channel can be used or parallel channels can be built. If the same channel is used, a message frame may have to be defined.

The electric potential of the IGDU can be freely selected, and the IGDUs may even share the same potential. A natural choice is that each IGDU is in the potential of the power module it is controlling. In case of an IGBT-module, this might be the potential of the auxiliary emitter. In this case, even though the power terminals of parallel power modules are electrically connected, the communication between the different IGDUs has to be isolated due to transient voltages caused by high current change rates and stray inductances in the power modules and the busbars. The IGDUs may themselves comprise the required galvanic isolation. The means for sending or the means for receiving reference information on switching events may, for instance, comprise a galvanic isolation. The galvanic isolation may also be implemented by using separate means.

The feedback information is used together with the reference information to determine the amount of unbalance. The IGDUs according to the present invention comprise means for calculating a value for a control parameter on the basis of the reference information and the feedback information.

In the simplest form, the intelligent gate driver units comprise means for determining a time of a reference switching device event on the basis of the received reference information and means for determining a time of a switching device event on the basis of the received feedback information. The control parameter is then calculated on the basis of the time difference between the switching device event and the reference switching device event.

In some embodiments of the present invention, a time integral difference of the currents of parallel-connected switching devices may also be used. The time difference and time integral difference may be used alone or together as control parameters.

One or more previous events may be used in the calculation. Information on temperature or temperature difference may also be used as a control parameter.

The IGDU according to the present invention also comprises means for controlling, on the basis of the switching device command and the control parameter, a control signal at the control output to control the switching device. The controlling may, for instance, be done by means of adjusting the switching times or controlling the gate voltages. The control objective may be to balance the currents between the switching devices. In some embodiments of the present invention, the temperature may be balanced by the intelligent IGDUs instead of balancing the currents. For this purpose, for example a coordinated exclusion of a switching device from the switching action or even from the conducting period can be applied. Furthermore, the concept may also be applied to balance the voltages of series-connected power modules.

The IGDUs may also have tasks, such as over-current protection and advanced gate control, so the IGDUs may comprise various voltage and temperature measurements. The IGDU according to the present invention may also comprise means for sending feedback information to the upper control. This may be done directly or via the parallel IGDUs.

By using the method according to the present invention, times of switching events of the parallel-connected switching devices can be brought closer to each other. Figure 4 illustrates convergence of switching times of four switching devices. The daisy chain strategy, similar to that illustrated in Figure 2 or 3, was applied. As the switching events of the parallel-connected switching devices approach each other, the currents become more balanced.

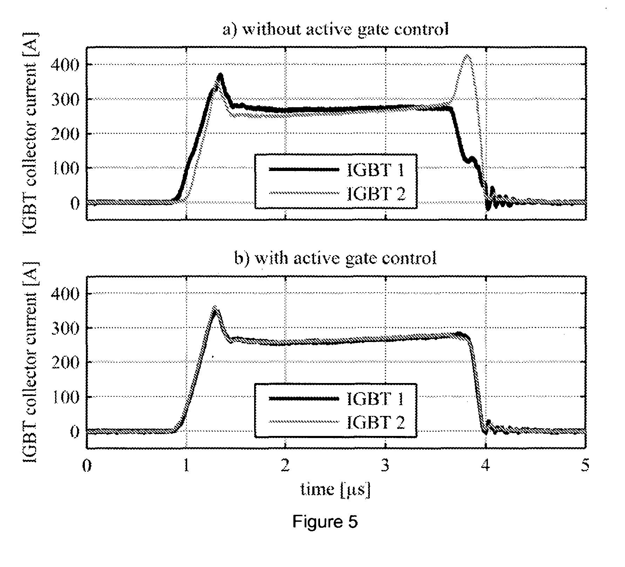

Figure 5 shows measured waveforms for two parallel switches, with and without active switching time correction for the two parallel switches. The upper part of Figure 5 shows an approximately 100 ns difference between the rising and falling edges of the two switching devices. This causes unbalance in the currents, particularly at the falling edges. The lower part of Figure 5 illustrates better performance due to more accurate control. The currents are practically equal.

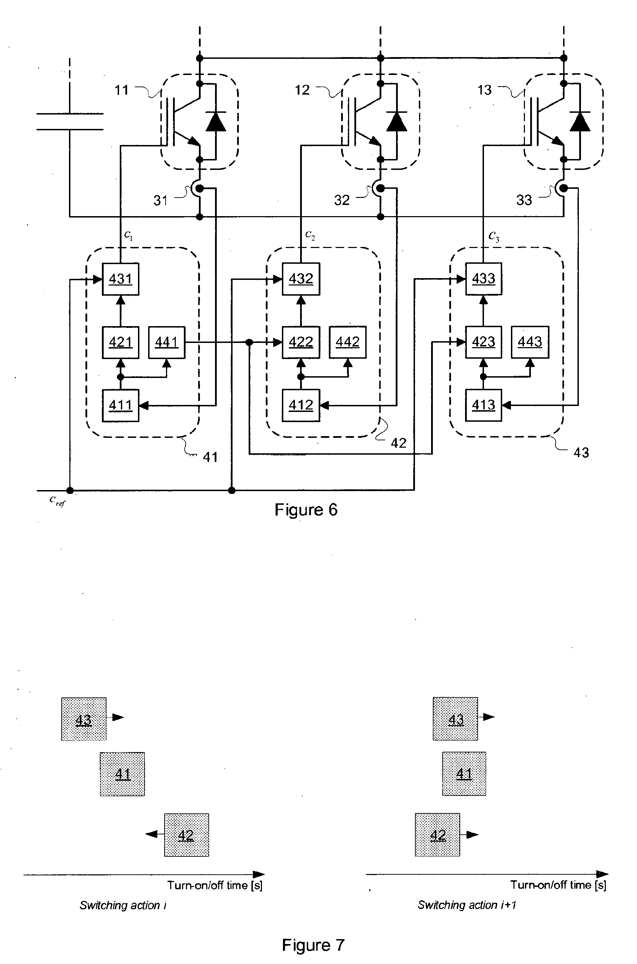

Figure 6 illustrates an embodiment of the present invention, using the master-slave approach. Three switching devices 11 to 13 are connected in parallel. Three IGDUs 41 to 43 control the switching devices 11 to 13. The IGDUs 41 to 43 are the same means as in Figure 3, now using only one master IGDU 41 as a source for a reference for the other slave IGDUs 42 and 43. In this embodiment the switching events are adjusted to balance the currents of the parallel-connected switching devices.

In Figure 7, an operational principle of the embodiment in Figure 6 is described schematically. At a switching action i the slave IGDU 42 detects that its switching event happens after the master IGDU 41 switching event and it makes a correction so that the switching event happens earlier. The slave IGDU 43 detects that its switching event happens before the master IGDU 41 switching event and it makes a correction so that the switching event happens later. At switching action *i*+1, the slave IGDU 42 notices that the switching delay was over compensated and it makes a correction for a later switching event. The slave IGDU 43 still switches before the master IGDU 41 and the correction is for a later switching event. As depicted in Figure 7, switching time adjusting is an ongoing action due to the jitter of digital sampling and other artifacts.

It will be obvious to a person skilled in the art that the inventive concept can be implemented in various ways. The embodiments of this document disclose apparatuses with parallel-connected switching devices. However, the method and intelligent gate driver units according to the present invention can also be used with series connected electrical switching devices to balance voltages over the switching devices. The invention and its embodiments are not limited to the examples described above but may vary within the scope of the claims.

## Claims

1. An apparatus comprising
two or more parallel or series connected electrical switching devices (11 to 1n), each switching device comprising a control terminal, the apparatus comprising two or more of intelligent gate driver units (41 to 4*n*), each intelligent gate driver unit comprising
a control output (*c*₁ to *cₙ*) connected to the control terminal of one of the switching devices (11 to 1*n*),
means (431 to 43*n*) for receiving turn-on and turn-off commands for the one of the switching devices (11 to 1*n*),
means (411 to 41*n*) for receiving feedback information on turn-on and turn-off events of the one of the switching devices (11 to 1*n*),
means (421 to 42*n*) for receiving reference information on turn-on and turn-off events of another switching device (11 to 1*n*),
means (421 to 42*n*) for calculating a value for a control parameter on the basis of the feedback information and the reference information, and
means (431 to 43*n*) for controlling, on the basis of the turn-on and turn-off commands and the control parameter, a control signal at the control output to control the one of the switching devices (11 to 1*n*), **characterized in that** the another switching device is a reference switching device selected from the two or more switching devices, the reference switching device being either a neighbouring switching device from the one of the switching devices or a master switching device selected as the reference switching device for all the intelligent gate driver units.

2. An apparatus according to claim 1, **characterized in that** the intelligent gate driver unit (41 to 4*n*) comprises
means for determining a time of a reference switching device event on the basis of the received reference information,
means for determining a time of a switching device event on the basis of the received feedback information,
means for calculating a value for the control parameter on the basis of the time of a reference switching device event and the time of a switching device event,
means for controlling, on the basis of the switching device command and the control parameter, a switching device (11 to 1*n*) in order to reduce the time difference between the reference switching device event and switching device event.

3. An apparatus according to claim 1 or 2, **characterized in that** the intelligent gate driver unit (41 to 4*n*) comprises means (441 to 44*n*) for sending the reference information to other intelligent gate driver units (41 to 4*n*), adapted to be connected to the means (421 to 42*n*) for receiving reference information of another intelligent gate driver unit (41 to 4*n*),

4. An apparatus according to any one of claims 1 to 3, **charac**- **terized** in that the intelligent gate driver units (41 to 4*n*) form a daisy chain adapted to pass reference information from one intelligent gate driver unit to another.

5. An apparatus according to any one of claims 1 to 3, **characterized in that** means (421 to 42*n*) for receiving reference information of two or more intelligent gate driver units (41 to 4*n*) are connected into one source for reference information.

6. An apparatus according to claim 3, **characterized in that** means (441 to 44*n*) for sending the reference information to other intelligent gate driver units (41 to 4*n*) comprises a galvanic isolation.

7. An apparatus according to any one of claims 1 to 5, **characterized in that** means (421 to 42*n*) for receiving reference information comprises a galvanic isolation.

8. A method for controlling switching devices (11 to 1*n*) comprising a control terminal, in an arrangement comprising a plurality of the switching devices, wherein the method controls the switching devices (11 to 1*n*) by using two or more intelligent gate driver units (21 to 2*n*), and the method comprises, for each intelligent gate driver unit (21 to 2*n*), steps of:
receiving turn-on and turn-off commands for one of the switching devices (11 to 1*n*),
receiving feedback information on turn-on and turn-off events of the one of the switching devices (11 to 1*n*),
receiving reference information on turn-on and turn-off events of another switching device (11 to 1*n*),
calculating a value for a control parameter on the basis of the reference information and feedback information, and
controlling, on the basis of the turn-on and turn-off commands and the control parameter, a control signal at control outputs (*c*₁ to *cₙ*) of the intelligent gate driver unit (21 to 2*n*), the output being connected to the control terminal of the switching device (11 to 1*n*), **characterized in that** the another switching device is a reference switching device selected from the two or more switching devices, the reference switching device being either a neighbouring switching device from the one of the switching devices or a master switching device selected as the reference switching device for all the intelligent gate driver units,

9. A method according to claim 8, **characterized in that** the reference information on switching events is passed from one intelligent gate driver unit (41 to 4*n*) to another, thus forming a daisy chain.

10. A method according to claim 8, **characterized in that** one intelligent gate driver unit (42 to 4*n*) is selected as a master whose switching event information is transferred to other intelligent gate driver units (41 to 4*n*) as a reference.

## Patentansprüche

1. Vorrichtung mit
zwei oder mehr parallel oder in Serie geschalteten elektrischen Schaltgeräten (11 to 1*n*), wobei jedes Schaltgerät ein Steuerterminal aufweist, welche Vorrichtung zwei oder mehr intelligente Gate-Treibereinheiten (41 bis 4*n*) aufweist, wobei jede intelligente Gate-Treibereinheit aufweist:
einen Steuerausgang (*c*₁ bis *cₙ*), der mit dem Steuerterminal eines der Schaltgeräte (11 bis 1*n*) verbunden ist,
Mittel (431 bis 43*n*) zum Empfangen von Einschalt- und Ausschaltbefehlen für das eine der Schaltgeräte (11 bis 1*n*),
Mittel (411 bis 41*n*) zum Empfangen von Feedback-Information über Einschalt- und Ausschaltvorgänge des einen der Schaltgeräte (11 bis 1*n*),
Mittel (421 bis 42*n*) zum Empfangen von Referenz-Information über Einschalt- und Ausschaltvorgänge eines anderen Schaltgeräts (11 bis 1*n*),
Mittel (421 bis 42*n*) zum Berechnen eines Werts für eine Steuergröße aufgrund der Feedback-information und der Referenz-Information und
Mittel (431 bis 43*n*) zum Steuern eines Steuersignals am Steuerausgang aufgrund der Einschalt- und Ausschaltbefehle und der Steuergröße, um das eine der Schaltgeräte (11 bis 1*n*) zu steuern, **dadurch gekennzeichnet, dass** das andere Schaltgerät ein Referenz-Schaltgerät ist, das aus den zwei oder mehr Schaltgeräten ausgewählt ist, wobei das Referenz-Schaltgerät entweder ein zum einen der Schaltgeräte benachbartes Schaltgerät oder ein Master-Schaltgerät ist, das als Referenz-Schaltgerät für alle intelligenten Gate-Treibereinheiten ausgewählt ist.

2. Vorrichtung nach Patentanspruch 1, **dadurch gekennzeichnet, dass** die intelligente Gate-Treibereinheit (41 bis 4*n*) aufweist:
Mittel zum Bestimmen einer Zeit eines Referenz-Schaltgerätvorgangs aufgrund der empfangenen Referenz-Information,
Mittel zum Bestimmen einer Zeit eines Schaltgerätvorgangs aufgrund der empfangenen Feedback-Information,
Mittel zum Berechnen eines Werts für die Steuergröße aufgrund der Zeit eines Referenz-Schaltgerätvorgangs und der Zeit eines Schaltgerätvorgangs,
Mittel zum Steuern eines Schaltgeräts (11 bis 1*n*) aufgrund des Schaltgerätbefehls und der Steuergröße, um den Zeitunterschied zwischen dem Referenz-Schaltgerätvorgang und dem Schaltgerätvorgang zu verringern.

3. Vorrichtung nach Patentanspruch 1 oder 2, **dadurch gekennzeichnet, dass** die intelligente Gate-Treibereinheit (41 bis 4*n*) Mittel (441 bis 44*n*) zum Senden der Referenz-Information an andere intelligente Gate-Treibereinheiten (41 bis 4*n*) aufweist, die angeordnet sind, mit den Mitteln (421 bis 42*n*) zum Empfangen von Referenz-Information einer anderen intelligenten Gate-Treibereinheit (41 bis 4*n*) verbunden zu werden.

4. Vorrichtung nach einem der Patentansprüche 1 bis 3, **dadurch gekennzeichnet, dass** die intelligenten Gate-Treibereinheiten (41 bis 4*n*) eine Verkettung ausbilden, die angeordnet ist, Referenz-Information von einer intelligenten Gate-Treibereinheit zur anderen zu übermitteln.

5. Vorrichtung nach einem der Patentansprüche 1 bis 3, **dadurch gekennzeichnet, dass** Mittel (421 bis 42*n*) zum Empfangen von Referenz-Information von zwei oder mehr intelligenten Gate-Treibereinheiten (41 bis 4*n*) zu einer Quelle für Referenz-Information verbunden werden.

6. Vorrichtung nach Patentanspruch 3, **dadurch gekennzeichnet, dass** Mittel (441 bis 44*n*) zum Senden der Referenz-Information an andere intelligente Gate-Treibereinheiten (41 bis 4*n*) eine galvanische Trennung aufweisen.

7. Vorrichtung nach einem der Patentansprüche 1 bis 5, **dadurch gekennzeichnet, dass** Mittel (421 bis 42*n*) zum Empfangen von Referenz-Information eine galvanische Trennung aufweisen.

8. Verfahren zur Steuerung von Schaltgeräten (11 bis 1*n*), die ein Steuerterminal aufweisen, in einer Anordnung, die mehrere Schaltgeräte aufweist, wobei das Verfahren die Schaltgeräte (11 bis 1*n*) anhand von zwei oder mehr intelligenten Gate-Treibereinheiten (21 bis 2*n*) steuert und das Verfahren für jede intelligente Gate-Treibereinheit (21 bis 2*n*) Schritte aufweist, in denen:
Einschalt- und Ausschaltbefehle für eines der Schaltgeräte (11 bis 1*n*) empfangen werden,
Feedback-Information über Einschalt- und Ausschaltvorgänge des einen der Schaltgeräte (11 bis 1*n*) empfangen wird,
Referenz-Information über Einschalt- und Ausschaltvorgänge eines anderen Schaltgeräts (11 bis 1*n*) empfangen wird,
ein Wert für eine Steuergröße aufgrund der Referenz-Information und Feedback-Information berechnet wird und
ein Steuersignal an Steuerausgängen (*c*₁ bis *cₙ*) der intelligenten Gate-Treibereinheit (21 bis 2*n*) aufgrund der Einschalt- und Ausschaltbefehle und der Steuergröße gesteuert wird, wobei der Ausgang mit dem Steuerterminal des Schaltgeräts (11 bis 1*n*) verbunden ist, **dadurch gekennzeichnet, dass** das andere Schaltgerät ein Referenz-Schaltgerät ist, das aus den zwei oder mehr Schaltgeräten ausgewählt ist, wobei das Referenz-Schaltgerät entweder ein zum einen der Schaltgeräte benachbartes Schaltgerät oder ein Master-Schaltgerät ist, das als Referenz-Schaltgerät für alle intelligenten Gate-Treibereinheiten ausgewählt ist.

9. Verfahren nach Patentanspruch 8, **dadurch gekennzeichnet, dass** die Referenz-Information über Schaltvorgänge von einer intelligenten Gate-Treibereinheit (41 bis 4*n*) zur anderen übermittelt wird, wobei eine Verkettung ausgebildet wird.

10. Verfahren nach Patentanspruch 8, **dadurch gekennzeichnet, dass** eine intelligente Gate-Treibereinheit (42 bis 4*n*) als Master ausgewählt wird, dessen Schaltvorgangsinformation anderen intelligenten Gate-Treibereinheiten (41 bis 4*n*) als Referenz übertragen wird.

## Revendications

1. Appareil comprenant :
au moins deux dispositifs de commutation électrique connectés en série ou en parallèle (11 to 1*n*), chaque dispositif de commutation comprenant une borne de commande, l'appareil comprenant au moins deux unités de commande grille intelligentes (41 à 4*n*), chaque unité de commande de grille intelligente comprenant :
une sortie de commande (*c*₁ bis *cₙ*) connectée à la borne de commande de l'un des dispositifs de commutation (11 à 1*n*) ;
des moyens (431 à 43*n*) destinés à recevoir des commandes de blocage et de déblocage de l'un des dispositifs de commutation (11 à 1*n*) ;
des moyens (411 à 41*n*) destinés à recevoir des informations en retour relatives aux événements de blocage et de déblocage de l'un des dispositifs de commutation (11 à 1*n*) ;
des moyens (421 à 42*n*) destinés à recevoir des informations de référence relatives à des événements de blocage et de déblocage d'un autre des dispositifs de commutation (11 à 1*n*) ;
des moyens (421 à 42*n*) destinés à calculer une valeur d'un paramètre de commande sur la base des informations en retour et des informations de référence ; et
des moyens (431 à 43*n*) destinés à commander, sur la base des commandes de blocage et de déblocage et du paramètre de commande, un signal de commande au niveau de la sortie de commande de façon à commander l'un des dispositifs de commutation (11 à 1*n*), **caractérisé en ce que** l'autre dispositif de commutation est un dispositif de commutation de référence sélectionné parmi les au moins deux dispositifs de commutation, le dispositif de commutation de référence étant soit un dispositif de commutation voisin de l'un des dispositifs de commutation soit un dispositif de commutation maître sélectionné en tant que dispositif de commutation de référence de toutes les unités de commande de grille intelligentes.

2. Appareil selon la revendication 1, **caractérisé en ce que** l'unité de commande grille intelligente (41 à 4*n*) comprend :
des moyens destinés à déterminer l'instant d'occurrence d'un événement de dispositif de commutation de référence sur la base des informations de référence reçues ;
des moyens destinés à déterminer l'instant d'occurrence d'un événement de dispositif de commutation sur la base des informations en retour reçues ;
des moyens destinés à calculer une valeur du paramètre de commande sur la base de l'instant d'occurrence d'un événement de dispositif de commutation de référence et de l'instant d'occurrence d'un événement de dispositif de commutation ;
des moyens destinés à commander, sur la base de la commande de dispositif de commutation et du paramètre de commande, un dispositif de commutation (11 à 1*n*) de façon à réduire la différence de temps entre l'événement de dispositif de commutation de référence et l'événement de dispositif de commutation.

3. Appareil selon la revendication 1 ou la revendication 2, **caractérisé en ce que** l'unité de commande de grille intelligente (41 à 4*n*) comprend des moyens (441 à 44*n*) destinés à envoyer des informations de référence à d'autres unités de commande de grille intelligentes (41 à 4*n*), conçus de façon à être connectés aux moyens (421 à 42*n*) destinés à recevoir des informations de référence d'une autre unité de commande de grille intelligente (41 à 4*n*).

4. Appareil selon l'une quelconque des revendications 1 à 3, **caractérisé en ce que** les unités de commande de grille intelligentes (41 à 4*n*) forment une chaîne conçue de façon à transmettre des informations de référence d'une unité de commande de grille intelligente à l'autre.

5. Appareil selon l'une quelconque des revendications 1 à 3, **caractérisé en ce que** les moyens (421 à 42*n*) destinés à recevoir les informations de référence des au moins deux unités de commande de grille intelligentes (41 à 4*n*), sont connectés à une source d'informations de référence.

6. Appareil selon la revendication 3, **caractérisé en ce que** les moyens (441 à 44*n*) destinés à envoyer les informations de référence à d'autres unités de commande de grille intelligentes (41 à 4*n*) comprennent un isolement galvanique.

7. Appareil selon l'une quelconque des revendications 1 à 5, **caractérisé en ce que** les moyens (421 à 42*n*) destinés à recevoir les informations de référence comprennent un isolement galvanique.

8. Procédé destiné à commander des dispositifs de commutation (11 à 1*n*) qui comprennent une borne de commande, dans un agencement qui comprend une pluralité de dispositifs de commutation, dans lequel le procédé commande les dispositifs de commutation (11 à 1*n*) en utilisant au moins deux unités de commande de grille intelligentes (21 à 2*n*), et le procédé comprend, pour chaque unité de commande de grille intelligente (21 à 2*n*), les étapes consistant à :
recevoir des commandes de blocage et de déblocage pour l'un des dispositifs de commutation (11 à 1*n*) ;
recevoir des informations en retour relatives à des événements de blocage et de déblocage de l'un des dispositifs de commutation (11 à 1*n*) ;
recevoir des informations de référence relatives à des événements de blocage et de déblocage d'un autre des dispositifs de commutation (11 à 1*n*) ;
calculer une valeur d'un paramètre de commande sur la base des informations de référence et des informations en retour ; et
commander, sur la base des commandes de blocage et de déblocage et du paramètre de commande, un signal de commande au niveau des sorties de commande (*c*₁ bis *cₙ*) de l'unité de commande de grille intelligente (21 à 2*n*), la sortie étant connectée à la borne de commande du dispositif de commutation (11 à 1*n*), **caractérisé en ce que** l'autre dispositif de commutation est un dispositif de commutation de référence sélectionné parmi au moins deux dispositifs de commutation, le dispositif de commutation de référence étant soit un dispositif de commutation voisin de l'un des dispositifs de commutation soit un dispositif de commutation maître sélectionné en tant que dispositif de commutation de référence de toutes les unités de commande de grille intelligentes.

9. Procédé selon la revendication 8, **caractérisé en ce que** les informations de référence relatives à des événements de commutation sont transmises d'une unité de commande de grille intelligente (41 à 4*n*) à une autre, en formant de ce fait une chaîne.

10. Procédé selon la revendication 8, **caractérisé en ce qu'**une unité de commande de grille intelligente (42 à 4*n*) est sélectionnée en tant que maître dont les informations d'événement de commutation sont transférées aux autres unités de commande de grille intelligentes (41 à 4*n*) en tant que référence.
